(19) Europäisches Patentamt
European Patent Office
Office européen des brevets

(11) **EP 3 871 480 B1**

(12) **EUROPÄISCHE PATENTSCHRIFT**

(45) Veröffentlichungstag und Bekanntmachung des Hinweises auf die Patenterteilung:
**11.10.2023 Patentblatt 2023/41**

(21) Anmeldenummer: **19716802.4**

(22) Anmeldetag: **25.03.2019**

(51) Internationale Patentklassifikation (IPC):
*H05K 13/08* (2006.01)   *G06Q 10/06* (2023.01)
*G06Q 50/04* (2012.01)   *G05B 19/418* (2006.01)
*G06Q 10/04* (2023.01)

(52) Gemeinsame Patentklassifikation (CPC):
**H05K 13/0857; G06Q 10/04; G06Q 50/04; H05K 13/085;** Y02P 90/02; Y02P 90/30

(86) Internationale Anmeldenummer:
**PCT/EP2019/057383**

(87) Internationale Veröffentlichungsnummer:
**WO 2020/192881 (01.10.2020 Gazette 2020/40)**

(54) **VERFAHREN ZUR BESTIMMUNG VON RÜSTFAMILIEN FÜR EINE BESTÜCKUNGSLINIE ZUR BESTÜCKUNG VON LEITERPLATTEN MIT ELEKTRONISCHEN BAUTEILEN**

METHOD FOR DETERMINING SET-UP FAMILIES FOR A PICK-AND-PLACE LINE FOR POPULATING CIRCUIT BOARDS WITH ELECTRONIC COMPONENTS

PROCÉDÉ DE DÉTERMINATION DE FAMILLES D'ÉQUIPEMENT D'UNE LIGNE D'ÉQUIPEMENT DESTINÉE À L'ÉQUIPEMENT DE CARTES DE CIRCUITS IMPRIMÉS AVEC DES COMPOSANTS ÉLECTRONIQUES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**01.09.2021 Patentblatt 2021/35**

(73) Patentinhaber: **Siemens Aktiengesellschaft**
**80333 München (DE)**

(72) Erfinder:
• **PFAFFINGER, Alexander**
**81739 München (DE)**
• **ROYER, Christian**
**85521 Ottobrunn (DE)**

(74) Vertreter: **Siemens Patent Attorneys**
**Postfach 22 16 34**
**80506 München (DE)**

(56) Entgegenhaltungen:
**EP-A1- 2 829 165       EP-A1- 2 829 166**
**DE-A1-102015 206 741**

**Beschreibung**

Die vorliegende Erfindung betrifft ein Verfahren zur Bestimmung von Rüstfamilien für eine Bestückungslinie zur Bestückung von Leiterplatten mit elektronischen Bauteilen bzw. Bauelementen. Weiterhin betrifft die Erfindung eine Steuereinrichtung für eine Fertigungs- oder Montagelinie zur Bestückung von Leiterplatten mit Bauelementen. Außerdem betrifft die Erfindung ein Computerprogrammprodukt und ein computerlesbares Medium.

Insbesondere im Bereich der Elektronikproduktion werden zu fertigende Leiterplatten bzw. Baugruppen auf SMT-Bestückungslinien durch Oberflächenmontage (surface mounted technology, SMT) hergestellt.

Eine Rüstfamilie ist bestimmt als eine Menge von Leiterplatten bzw. Baugruppen, die auf einer Bestückungslinie bestückt werden können, ohne die Menge der Bauteiltypen bzw. Bauelementtypen zu ändern, die an der Bestückungslinie für die Bestückung bereit gehalten sind. Bestehende Werkzeuge zur Bestimmung von Rüstfamilien erfordern häufig entweder einen manuellen Aufwand oder liefern nicht immer überzeugende Resultate. Andere bekannte Werkzeuge sind zur Verwendung an ein bestimmtes Bestückungssystem gebunden.

Aus EP 2 829 165 A1 ist ein Verfahren zur Zuordnung von Leiterplatten an Bestücklinien eine Bestückungssystem bekannt, das sich an den Anzahlen Rüstfamilien der Bestückungslinien als Zuordnungskriterium orientiert.

Aus DE 10 2015 206741 A1 ist ein Verfahren zur Steuerung einer Werkzeugmaschine mit einem Werkzeugmagazin für Werkzeuge bekannt, bei dem die Rüstfamilien der Werkstücke derart gebildet werden, dass die Zahl der Werkzeuge, die zur Bearbeitung der erfassten Werkstücke aufzurüsten sind, möglichst minimiert ist.

Es ist Aufgabe der vorliegenden Erfindung, eine verbesserte Technik zur Zuordnung bzw. zur Verteilung von Leiterplatten auf eine vorgegebene bzw. vorgebbare Anzahl von Rüstfamilien bereitzustellen mit minimaler Anzahl von zu rüstenden Bauteiltypen.

Eine minimale Anzahl von auf Wechseltischen zu rüstenden Bauteiltypen bringt eine Einsparung von Zeit und wirtschaftlichen Kosten mit sich, wobei die Wechseltische die Bauelemente für die Fertigung der Leiterplatten auf einer Linie vorhalten. Die Menge der an der Bestückungslinie bereit gehaltenen Bauelementtypen wird auch Rüstung genannt. Es wird üblicherweise davon ausgegangen, dass stets ausreichend viele Bauteile jedes Bauteiltyps an der Bestückungslinie bereitgehalten sind.

Diese Aufgabe wird durch die unabhängigen Ansprüche gelöst. Vorteilhafte Weiterbildungen sind Gegenstand der abhängigen Ansprüche.

Die Erfindung beansprucht ein Verfahren zur Bestimmung von Rüstfamilien für eine Bestückungslinie zur Bestückung von Leiterplatten mit elektronischen Bauteilen eines oder mehrerer Bauteiltypen, wobei das Verfahren folgende Schritte umfasst:

- Erfassen einer vorgegebenen oder vorgebbaren Anzahl von Rüstfamilien,
- wobei eine Rüstfamilie bestimmt ist als eine Menge von Leiterplatten, die auf einer Bestückungslinie bestückt werden können, ohne die Menge der Bauteiltypen zu ändern, die an der Bestückungslinie für die Bestückung bereitgehalten werden; dadurch gekennzeichnet, dass
- eine Zuordnung von zu verteilenden Leiterplatten auf die erfasste Anzahl der Rüstfamilien derart mittels einer ganzzahligen Linearen Programmierung optimiert wird, dass die Summe der Anzahlen an Bauteiltypen pro Rüstfamilie minimiert wird.

Ein Aspekt der Erfindung sieht vor, dass für die Menge der Bauteiltypen, die an der Bestückungslinie für die Bestückung bereitgehalten werden, ein maximaler Schwellenwert in Form eines maximalen Füllgrades vorgegeben wird.

Mit der gewonnenen Zuordnung kann die Bestückung der Leiterplatten in der ihnen zugeordneten Rüstfamilie durchgeführt werden.

Damit werden weniger Rüstplätze benötigt, da insgesamt eine redundante Rüstung von Bauteilen gleichen Bauteiltyps vermieden wird.

Die erfasste Anzahl von Rüstfamilien kann eine minimale Anzahl von Rüstfamilien repräsentieren.

Eine Weiterbildung der Erfindung sieht vor, dass die Zuordnung von zu verteilenden Leiterplatten auf die erfasste Anzahl der Rüstfamilien zudem derart erfolgt, dass die Leiterplatten einer Teilmenge der zu verteilenden Leiterplatten derselben Rüstfamilie zugeordnet wird.

Eine Weiterbildung der Erfindung sieht vor, dass die Zuordnung von zu verteilenden Leiterplatten auf die erfasste Anzahl der Rüstfamilien zudem derart erfolgt, dass die Leiterplatten einer Teilmenge der zu verteilenden Leiterplatten jeweils einer anderen Rüstfamilie zugeordnet werden.

Mit dem Verfahren lassen sich für kleine und mittlere Problemgrößen, wie z.B. für die Festrüstungslinien in relativ kurzer Zeit sehr gute Ergebnisse erzielen. Zudem ist das Verfahren sehr flexibel, d.h. es können leicht zusätzliche Restriktionen und weitere niedrig gewichtete Zielfunktionskomponenten eingebaut werden. Bei Reduzierung von Festrüstungen ergeben sich zeitliche und wirtschaftliche Einsparungen. Das Verfahren kann mit allen üblichen Bestückungslinien verwendet werden.

Ein weiterer Aspekt der Erfindung sieht eine Steuerungseinrichtung vor, die insbesondere zur Durchführung des Verfahrens nach oben genannter Art und dessen Ausführungsformen ausgebildet ist. Die Steuerungseinrichtung kann ein dem Bestückungssystem beigeordneter und ggf. abgesetzt angeordneter Rechner oder ein in das Bestückungssystem integriertes Steuerungsmodul sein.

Die Steuerungseinrichtung zur Bestimmung von Rüstfamilien für eine Bestückungslinie zur Bestückung von Leiterplatten mit elektronischen Bauteilen eines oder mehrerer Bauteiltypen, weist auf:

- Mittel zum Erfassen einer vorgegebenen oder vorgebbaren Anzahl von Rüstfamilien,
- wobei eine Rüstfamilie bestimmt ist als eine Menge von Leiterplatten, die auf einer Bestückungslinie bestückt werden können, ohne die Menge der Bauteiltypen zu ändern, die an der Bestückungslinie für die Bestückung bereit gehalten werden; Gekennzeichnet durch
- Mittel zur Zuordnung von zu verteilenden Leiterplatten auf die erfasste Anzahl der Rüstfamilien, die dazu ausgelegt sind, diese Zuordnung derart mittels einer ganzzahligen Linearen Programmierung zu optimieren, dass die Summe der Anzahlen an Bauteiltypen pro Rüstfamilie minimiert wird, und
- Mittel zur Durchführung der Bestückung der Leiterplatten in der ihnen zugeordneten Rüstfamilie.

Ein Aspekt der Erfindung sieht vor, dass für die Menge der Bauteiltypen, die an der Bestückungslinie für die Bestückung bereitgehalten werden, ein maximaler Schwellenwert in Form eines maximalen Füllgrades vorgegeben wird.

Ein weiterer Aspekt der Erfindung ist ein Computerprogramm(-produkt) mit Programmcodemitteln zur Durchführung des Verfahrens nach einem der vorangehenden Verfahrensansprüche, wenn es auf einer Steuerungseinrichtung der oben genannten Art abläuft oder auf einem computerlesbaren Medium gespeichert ist.

Das Computerprogramm bzw. -produkt kann auf einem computerlesbaren Medium gespeichert sein. Das Computerprogramm bzw. -produkt kann in einer üblichen Programmiersprache (z.B. C++, Java) erstellt sein. Die Verarbeitungseinrichtung kann einen marktüblichen Computer oder Server mit entsprechenden Eingabe-, Ausgabe- und Speichermitteln umfassen. Diese Verarbeitungseinrichtung kann in der Steuerungseinrichtung oder in deren Mitteln integriert sein.

Die Steuerungseinrichtung sowie das Computerprogramm(-produkt) können analog zum oben genannten Verfahren weiter- bzw. ausgebildet sein.

Weitere Vorteile, Einzelheiten und Weiterbildungen der Erfindung ergeben sich aus der nachfolgenden Beschreibung von Ausführungsbeispielen in Verbindung mit den Zeichnungen.

Es zeigen:

Fig. 1    ein Bestückungssystem;

Fig. 2    eine Veranschaulichung zur Bildung von Rüstfamilien am Bestückungssystem von Fig. 1 gemäß der Erfindung.

Eine mögliche Optimierungsmethode zur Optimierung der Zuordnung der zu verteilenden Leiterplatten ist die lineare Optimierung. Sie befasst sich mit der Optimierung linearer Zielfunktionen über einer Menge, die durch lineare Gleichungen und Ungleichungen eingeschränkt ist. Sie ist Grundlage der Lösungsverfahren der (gemischt-) ganzzahligen linearen Optimierung. Ein sogenannter Solver (Löser) ist eine Sammelbezeichnung für spezielle mathematische Computerprogramme, die mathematische Probleme numerisch lösen können. Im Zusammenhang mit MILP (mixed integer linear programming bzw. gemischt ganzzahlige lineare Programmierung) können für IP-Programme (ganzzahlige Optimierungsmodelle) Standardsolver wie z.B. CPLEX, Scip, Gurobi, Xpress verwendet werden.

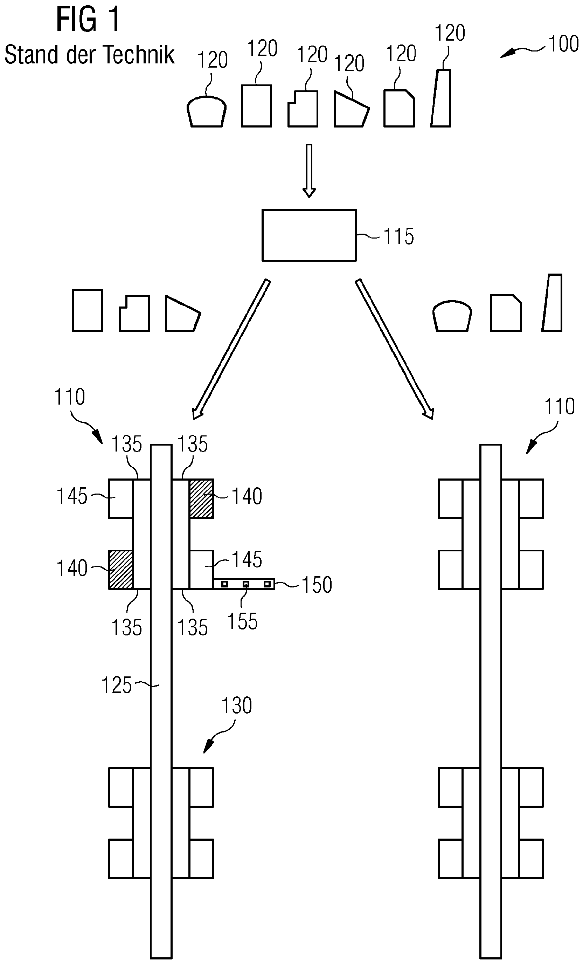

Figur 1 zeigt ein Bestückungssystem 100. Das Bestückungssystem 100 umfasst mehrere Bestückungslinien 110 und eine Steuereinrichtung 115 zur Zuordnung von Leiterplatten 120 an die Bestückungslinien 110. Jede Bestückungslinie 110 umfasst üblicherweise ein Transportsystem 125 und ein oder mehrere Bestückungsautomaten 130. Jeder Bestückungsautomat 130 umfasst einen oder mehrere Bestückungsköpfe 135, die jeweils dazu eingerichtet sind, von einem konstanten Tisch 140 oder einem variablen Tisch 145 Bauelemente aufzunehmen und an einer vorbestimmten Position auf der Leiterplatte 120 zu positionieren, die sich auf dem Transportsystem 125 befindet.

Während des Bestückungsvorgangs besteht die Leiterplatte 120 bezüglich des Bestückungsautomaten 130 üblicherweise still. Die Tische 140, 145 umfassen jeweils eine Vielzahl Zuführungseinrichtungen 150, von denen nur eine exemplarisch dargestellt ist. Jede Zuführungseinrichtung 150 hält einen Vorrat von Bauteilen 155 eines vorbestimmten Typs bereit. Zwar kann jede Zuführungseinrichtung 150 zur Bereithaltung unterschiedlicher Bauteile bzw. Bauelemente 155 konfiguriert werden und unterschiedliche Zuführungseinrichtungen 150 an einem Tisch 140, 145 angebracht werden, jedoch werden die Tische 140, 145 aus Geschwindigkeitsgründen üblicherweise komplett ausgetauscht, wenn ein Bestückungsautomat 130 mit Bauteilen 155 versorgt werden muss, die nicht auf einem der angebrachten Tische 140, 145 vorgehalten sind.

Da ein solcher Wechsel üblicherweise mit einem Produktionsstillstand verbunden ist, wird angestrebt, die Zahl der zu wechselnden Tische 140, 145 gering zu halten. Wird ein Tisch während eines Umrüstvorgangs nicht ausgetauscht, so wird er als konstanter Tisch 140 bezeichnet, ansonsten als variabler Tisch 145. Funktionale Unterschiede zwischen einem konstanten Tisch 140 und einem variablen Tisch 145 bestehen ansonsten nicht.

Die Leiterplatte 120 ist mit einer Anzahl unterschiedlicher Bauteile 155 zu bestücken. Um ein häufiges Wechseln von variablen Tischen 145 zu minimieren und idealerweise eine Zahl konstanter Tische 140 zu maximieren, ist die Steuerungseinrichtung 115 dazu eingerichtet, die Zuordnung einer Leiterplatte 120 an eine der Bestückungslinien 110 zu optimieren. Dabei müssen üblicherweise spezifische Eigenschaften jeder Bestückungslinie 110 bzw. jedes Bestückungsautomaten 130 genauso berücksichtigt werden, wie Eigenschaften der Leiterplatten 120 bzw. der auf ihnen zu bestückenden Bauteile 155.

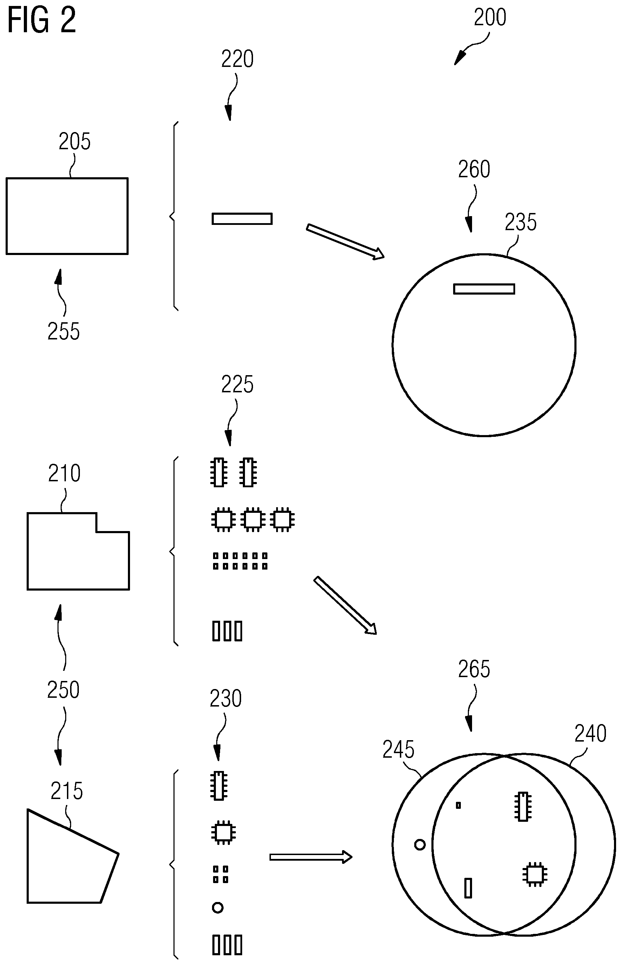

Figur 2 zeigt eine Veranschaulichung 200 von Rüstfamilien, auch "Cluster" genannt. Betrachtet werden eine erste Leiterplatte 205, eine zweite Leiterplatte 210 und eine dritte Leiterplatte 215, die jeweils einer der Leiterplatten 120 im Bestückungssystem 100 aus Figur 1 entsprechen. Auf der ersten Leiterplatte 205 ist eine erste Menge 220 von Bauteilen 155, auf der zweiten Leiterplatte 210 eine zweite Menge 225 von Bauteilen 155 und auf der dritten Leiterplatte 215 eine dritte Menge 230 von Bauteilen 155 zu bestücken. In exemplarischer Weise umfassen die Mengen 220, 225 und 230 jeweils unterschiedliche Bauteil- bzw. Bauelementtypen, die mit unterschiedlichen Formen gekennzeichnet sind und von denen jeweils Bauteile 155 in unterschiedlichen Anzahlen verwendet werden. Den Mengen 220 bis 230 von Bauteilen 155 sind daher Mengen 235 bis 245 von Bauteiltypen zugeordnet. In den Mengen 235 bis 245 findet sich jedes der unterschiedlichen Bauteile 155 der entsprechenden Menge 220 bis 230 nur einmal wieder.

Eine Rüstfamilie umfasst diejenigen Leiterplatten 120, die zur Bestückung auf einer Bestückungslinie 100 zugeordnet sind. Im Beispiel von Figur 2 sind die Leiterplatten 210 und 215 der gleichen Bestückungslinie 110 zugeordnet und bilden eine erste Rüstfamilie 250. Die erste Rüstfamilie 250 erfordert daher eine erste Rüstung 265 mit Bauteiltypen, die den Leiterplatten 210 und 215 zugeordnet sind. Im dargestellten Beispiel umfasst die erste Rüstung 265 fünf Bauteiltypen. Unter Bereitstellung des Bauteiltyps der ersten Rüstung 265 lassen sich die Leiterplatten 210 und 215 der ersten Rüstfamilie 250 ohne Umrüstung auf der Bestückungslinie 110 bestücken, wobei davon ausgegangen wird, dass höchstens fünf verschiedenen Bauteiltypen in einer Rüstung Platz finden.

Die dritte Leiterplatte 205 bildet allein eine zweite Rüstfamilie 255. Eine der zweiten Rüstfamilie 255 zugeordnete zweite Rüstung 260 umfasst einen Bauteiltyp.

Die Summe der Bauteiltypen in den beiden Rüstungen ist minimal.

Das erfindungsgemäße Verfahren nutzt die Freiheitsgrade bei der individuellen Verteilung der Leiterpatten auf die eine erfasste vorgegebene/vorgebbare oder zuvor berechnete bzw. bestimmte Anzahl von Rüstfamilien aus. Mittels einer ganzzahligen Linearen Programmierung wird eine Zielfunktion berechnet. Mit dieser Zielfunktion wird die Summe der Anzahlen an Bauteiltypen pro Rüstfamilie minimiert. Wenn das Beispiel in Figur 2 betrachtet wird, wird dadurch die zweite Leiterplatte 210 nicht der gleichen Rüstfamilie wie die Leiterplatte 205, sondern der gleichen Rüstfamilie wie die Leiterplatte 215 zugeordnet. Dadurch weist die Menge 235 einen Bauelementtyp und die Menge 240 vereinigt mit Menge 245 fünf Bauelementtypen auf. Die Summe der Anzahlen (eins plus fünf) an Bauteiltypen pro Rüstfamilie beträgt hierbei sechs und nicht zehn (fünf plus fünf), wenn die zweite Leiterplatte 210 der gleichen Rüstfamilie wie die Leiterplatte 205 zugeordnet würde. Damit werden weniger Rüstplätze benötigt, da insgesamt eine redundante Rüstung von Bauteilen gleichen Bauteiltyps vermieden wird

Es können mit dem erfindungsgemäßen Verfahren zusätzliche Restriktionen berücksichtigt werden:

- Auf der Bestückungslinie gibt es Bauelement-Tisch-Restriktionen, d.h. Bauelemente dürfen nicht auf allen Tischen, sondern nur auf eine Teilmenge der Tische 140, 145 gerüstet werden.
- Der maximale Füllgrad einer Zuführeinrichtung kann eingehalten werden.
- Leiterplatten einer ersten Teilmenge der zu erteilenden Leiterplatten muss in dasselbe Cluster (z.B. die Ober- und Unterseite einer Leiterplatte) verteilt werden.
- Leiterplatten einer zweiten Teilmenge der Leiterplatten darf nicht demselben Cluster, sondern muss jeweils in ein anderes Cluster zugeordnet werden.

Mathematischer Hintergrund

Durch den Einsatz von exakten mathematischen Verfahren lassen sich deutlich bessere Lösungen erzielen als mit bisher in der Praxis verwendeten Heuristiken.

In der nachfolgend beschriebenen MILP-Formulierung gelten die folgenden Bezeichnungen:

**Indices**

R     Menge der Leiterplatten 120

C    Menge der Bauelementtypen 155
F    Menge der Rüstfamilien 250, 255 mit vorgegebener Anzahl
$R_c$    Menge der Leiterplatten mit Bauelementtyp c

Aus EP 2 829 166 B1 ist ein Verfahren zur Bildung von Rüstfamilien auf Bestückungslinien bekannt. Es wird hierin ein Verfahren beschrieben, mit dem bei gegebener Bestückungslinie und Leiterplattenmenge eine Menge von Rüstfamilien mit minimaler Anzahl bestimmt und damit für obiges F vorgegeben werden kann. Es sind jedoch auch andere Verfahren oder auch eine manuelle Eingabe denkbar, die die minimale Anzahl vorgeben können. Zudem kann auch eine beliebige andere Anzahl vorgegeben werden.

**Parameter**

$CapUsage_c$    Spurverbrauch von Bauelement c
$Cap_f$    Anzahl der verfügbaren Spuren in der Rüstung von Rüstfamilie f

**Binär-Variablen**

$x_{r,f}$    Zuordnung Leiterplatte r zu Rüstfamilie f
$y_{c,f}$    Verwendung eines Bauelements c in Rüstfamilie f

**IP Formulierung**

$$\text{Minimiere } \sum_{f \in F} \sum_{c \in C} y_{c,f}$$

**Nebenbedingungen:**

(1) Jeder Leiterplattentyp muss genau einer Rüstfamilie zugeordnet sein:

$$\sum_{f \in F} x_{r,f} = 1 \qquad\qquad r \in R$$

(2) Wird eine Leiterplatte einer Rüstfamilie zugewiesen, so müssen auch alle Bauelementtypen dieser Leiterplatte in der Rüstung dieser Rüstfamilie gerüstet werden:

$$x_{r,f} \leq y_{c,f} \qquad\qquad c \in C, f \in F, r \in R_c$$

(3) Alle Bauelementtypen der Leiterplatten einer Rüstfamilie müssen mit ihrem Spurverbrauch in eine Rüstung passen:

$$\sum_{c \in C} CapUsage_c \, y_{c,f} \leq Cap_f \qquad\qquad f \in F$$

(4) Variablenrestriktionen:

$$y_{c,f} \in \{0,1\} \qquad\qquad c \in C, f \in F$$

$$x_{r,f} = \{0,1\} \qquad\qquad r \in R, f \in F$$

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Die Implementierung der vorstehend beschriebenen Prozesse oder Verfahrensabläufe kann anhand von Instruktionen erfolgen, die auf computerlesbaren Speichermedien oder in flüchtigen Computerspeichern (im Folgenden zusammenfassend als computerlesbare Speicher bezeichnet) vorliegen. Computerlesbare Speicher sind beispielsweise flüchtige Speicher wie Caches, Puffer oder RAM sowie nichtflüchtige Speicher wie Wechseldatenträger, Festplatten, usw.

Die vorstehend beschriebenen Funktionen oder Schritte können dabei in Form zumindest eines Instruktionssatzes in/auf einem computerlesbaren Speicher vorliegen. Die Funktionen oder Schritte sind dabei nicht an einen bestimmten Instruktionssatz oder an eine bestimmte Form von Instruktionssätzen oder an ein bestimmtes Speichermedium oder an einen bestimmten Prozessor oder an bestimmte Ausführungsschemata gebunden und können durch Software, Firmware, Microcode, Hardware, Prozessoren, integrierte Schaltungen usw. im Alleinbetrieb oder in beliebiger Kombination ausgeführt werden. Dabei können verschiedenste Verarbeitungsstrategien zum Einsatz kommen, beispielsweise serielle Verarbeitung durch einen einzelnen Prozessor oder Multiprocessing oder Multitasking oder Parallelverarbeitung usw.

Die Instruktionen können in lokalen Speichern abgelegt sein, es ist aber auch möglich, die Instruktionen auf einem entfernten System abzulegen und darauf via Netzwerk zuzugreifen.

Unter "rechnergestützt" kann im Zusammenhang mit der Erfindung beispielsweise eine Implementierung des Verfahrens verstanden werden, bei dem insbesondere ein Prozessor mindestens einen Verfahrensschritt des Verfahrens ausführt. Eine oben beschriebene Steuerungseinrichtung kann einen solchen Prozessor aufweisen.

Der Begriff "Prozessor", "zentrale Signalverarbeitung", "Steuereinheit" oder "Datenauswertemittel", wie hier verwendet, umfasst Verarbeitungsmittel im weitesten Sinne, also beispielsweise Server, Universalprozessoren, Grafikprozessoren, digitale Signalprozessoren, anwendungsspezifische integrierte Schaltungen (ASICs), programmierbare Logikschaltungen wie FPGAs, diskrete analoge oder digitale Schaltungen und beliebige Kombinationen davon, einschließlich aller anderen dem Fachmann bekannten oder in Zukunft entwickelten Verarbeitungsmittel. Prozessoren können dabei aus einer oder mehreren Vorrichtungen bzw. Einrichtungen bzw. Einheiten bestehen. Besteht ein Prozessor aus mehreren Vorrichtungen, können diese zur parallelen oder sequentiellen Verarbeitung bzw. Ausführung von Instruktionen ausgelegt bzw. konfiguriert sein. Unter einer "Speichereinheit" kann im Zusammenhang mit der Erfindung beispielsweise ein Speicher in Form von Arbeitsspeicher (engl. Random-Access Memory, RAM) oder eine Festplatte verstanden werden.

## Patentansprüche

1. Verfahren zur Bestimmung von Rüstfamilien (250, 255) für eine Bestückungslinie (110) zur Bestückung von Leiterplatten (120) mit elektronischen Bauteilen (155) eines oder mehrerer Bauteiltypen, wobei das Verfahren folgende Schritte umfasst:

   - Erfassen einer vorgegebenen oder vorgebbaren Anzahl von Rüstfamilien (250, 255),
   - wobei eine Rüstfamilie bestimmt ist als eine Menge von Leiterplatten, die auf einer Bestückungslinie bestückt werden können, ohne die Menge der Bauteiltypen zu ändern, die an der Bestückungslinie für die Bestückung bereit gehalten werden;
   - wobei eine Zuordnung von zu verteilenden Leiterplatten auf die erfasste Anzahl der Rüstfamilien derart mittels einer ganzzahligen Linearen Programmierung optimiert wird, dass die Summe der Anzahlen an Bauteiltypen pro Rüstfamilie minimiert wird, wobei für die Menge der Bauteiltypen, die an der Bestückungslinie für die Bestückung bereit gehalten werden, ein maximaler Schwellenwert in Form eines maximalen Füllgrades vorgegeben wird, und
   - Durchführung der Bestückung der Leiterplatten in der ihnen zugeordneten Rüstfamilie.

2. Verfahren nach dem vorhergehenden Anspruch, wobei die erfasste Anzahl von Rüstfamilien eine minimale Anzahl von Rüstfamilien repräsentiert.

3. Verfahren nach einem der vorhergehenden Ansprüche, wobei die Zuordnung von zu verteilenden Leiterplatten auf die erfasste Anzahl von Rüstfamilien zudem derart erfolgt, dass die Leiterplatten einer ersten Teilmenge der zu verteilenden Leiterplatten derselben Rüstfamilie zugeordnet werden.

4. Verfahren nach Anspruch 3, wobei die Zuordnung von zu verteilenden Leiterplatten auf die erfasste Anzahl der Rüstfamilien zudem derart erfolgt, dass die Leiterplatten einer zweiten Teilmenge der zu verteilenden Leiterplatten jeweils einer anderen Rüstfamilie zugeordnet werden.

5. Steuerungseinrichtung zur Bestimmung von Rüstfamilien (250, 255) für eine Bestückungslinie (110) zur Bestückung von Leiterplatten (120) mit elektronischen Bauteilen (155) eines oder mehrerer Bauteiltypen, aufweisend:

 - Mittel zum Erfassen einer vorgegebenen oder vorgebbaren Anzahl von Rüstfamilien (250, 255),
 - wobei eine Rüstfamilie bestimmt ist als eine Menge von Leiterplatten, die auf einer Bestückungslinie bestückt werden können, ohne die Menge der Bauteiltypen zu ändern, die an der Bestückungslinie für die Bestückung bereit gehalten werden;
 - Mittel zur Zuordnung von zu verteilenden Leiterplatten auf die erfasste Anzahl der Rüstfamilien, die dazu ausgelegt sind, diese Zuordnung derart mittels einer ganzzahligen Linearen Programmierung zu optimieren, dass die Summe der Anzahlen an Bauteiltypen pro Rüstfamilie minimiert wird, wobei für die Menge der Bauteiltypen, die an der Bestückungslinie für die Bestückung bereit gehalten werden, ein maximaler Schwellenwert in Form eines maximalen Füllgrades vorgegeben wird, und
 - Mittel zur Durchführung der Bestückung der Leiterplatten in der ihnen zugeordneten Rüstfamilie.

6. Computerprogrammprodukt mit Programmcodemitteln zur Durchführung des Verfahrens nach einem der vorangehenden Verfahrensansprüche, wenn es auf einer Steuerungseinrichtung nach einem der vorangehenden Steuerungseinrichtungsansprüche abläuft.

**Claims**

1. Method for determining set-up families (250, 255) for a pick-and-place line (110) for populating circuit boards (120) with electronic components (155) of one or more component types, wherein the method comprises the following steps:

 - detecting a predetermined or predeterminable number of set-up families (250, 255),
 - wherein a set-up family is defined as a quantity of circuit boards that can be populated on a pick-and-place line without changing the quantity of component types that are kept ready for population on the pick-and-place line;
 - wherein an assignment of circuit boards to be distributed to the detected number of set-up families is optimized by means of integer linear programming in such a way that the sum of the numbers of component types per set-up family is minimized, wherein a maximum threshold value in the form of a maximum degree of filling is predetermined for the quantity of component types that are kept ready for population on the pick-and-place line, and
 - populating the circuit boards in the set-up family assigned to them.

2. Method according to the preceding claim,
 wherein the detected number of set-up families represents a minimum number of set-up families.

3. Method according to one of the preceding claims, wherein the assignment of circuit boards to be distributed to the detected number of set-up families also takes place in such a way that the circuit boards of a first sub-quantity of the circuit boards to be distributed are assigned to the same set-up family.

4. Method according to Claim 3, wherein circuit boards to be distributed to the detected number of set-up families are also assigned in such a way that the circuit boards of a second sub-quantity of the circuit boards to be distributed are assigned in each case to a different set-up family.

5. Control device for determining set-up families (250, 255) for a pick-and-place line (110) for populating circuit boards (120) with electronic components (155) of one or more component types, having:

 - means for detecting a predetermined or predeterminable number of set-up families (250, 255),
 - wherein a set-up family is defined as a quantity of circuit boards that can be populated on a pick-and-place line without changing the quantity of component types that are kept ready for population on the pick-and-place line;
 - means for assigning circuit boards to be distributed to the detected number of set-up families which are designed to optimize this assignment by means of integer linear programming in such a way that the sum of the number of component types per set-up family is minimized, wherein a maximum threshold value in the form of a maximum degree of filling is predetermined for the quantity of component types that are kept ready for population on the pick-and-place line, and
- means for populating the circuit boards in the set-up family assigned to them.

**6.** Computer program product with program code means for carrying out the method according to one of the preceding method claims when it runs on a control device according to one of the preceding control device claims.

**Revendications**

**1.** Procédé de détermination de familles d'équipement (250, 255) pour une ligne d'insertion (110) permettant d'insérer des composants électroniques (155) correspondant à un ou plusieurs type(s) de composants sur des circuits imprimés (120), dans lequel le procédé comprend les étapes ci-dessous consistant à :

- enregistrer un nombre prédéfini ou pouvant être prédéfini de familles d'équipement (250, 255),
- dans lequel une famille d'équipement est définie comme étant un ensemble de circuits imprimés pouvant être montés sur une ligne d'insertion sans modifier la quantité de types de composants qui sont maintenus à disposition sur la ligne d'insertion en vue de l'insertion ;
- dans lequel l'affectation des circuits imprimés à répartir au nombre enregistré de familles d'équipement est optimisée au moyen d'une programmation linéaire en nombres entiers de telle manière que la somme des nombres de types de composants par famille d'équipement est minimisée, dans lequel une valeur de seuil maximale sous la forme d'un degré de remplissage maximal est prédéfinie pour la quantité de types de composants qui sont maintenus à disposition sur la ligne d'insertion en vue de l'insertion, et
- mettre en oeuvre l'insertion, sur les circuits imprimés, de la famille d'équipement qui leur est affectée.

**2.** Procédé selon la revendication précédente, dans lequel le nombre enregistré de familles d'équipement représente un nombre minimal de familles d'équipement.

**3.** Procédé selon l'une quelconque des revendications précédentes, dans lequel l'affectation de circuits imprimés à répartir au nombre enregistré de familles d'équipement intervient en outre de telle manière que les circuits imprimés d'un premier sous-ensemble des circuits imprimés à répartir sont affectés à la même famille d'équipement.

**4.** Procédé selon la revendication 3, dans lequel l'affectation de circuits imprimés à répartir au nombre enregistré des familles d'équipement intervient en outre de telle manière que les circuits imprimés d'un second sous-ensemble des circuits imprimés à répartir sont affectés respectivement à une autre famille d'équipement.

**5.** Dispositif de commande permettant de déterminer des familles d'équipement (250, 255) pour une ligne d'insertion (110) permettant d'insérer des composants électroniques (155) d'un ou plusieurs type(s) de composants sur des circuits imprimés (120), présentant :

- des moyens permettant d'enregistrer un nombre prédéterminé ou pouvant être prédéterminé de familles d'équipement (250, 255),
- dans lequel une famille d'équipement est définie comme étant un ensemble de circuits imprimés pouvant être montés sur une ligne d'insertion sans modifier la quantité de types de composants qui sont maintenus à disposition sur la ligne d'insertion en vue de l'insertion ;
- des moyens permettant d'affecter des circuits imprimés à répartir au nombre enregistré de familles d'équipement et conçus afin d'optimiser ladite affectation au moyen d'une programmation linéaire en nombres entiers de telle manière que la somme des nombres de types de composants par famille d'équipement est minimisée, dans lequel une valeur de seuil maximale sous la forme d'un degré de remplissage maximal est prédéfinie pour la quantité de types de composants qui sont maintenus à disposition sur la ligne d'insertion en vue de l'insertion, et
- des moyens permettant de mettre en oeuvre l'insertion, sur les circuits imprimés, de la famille d'équipement qui leur est affectée.

**6.** Produit de programme informatique comprenant des moyens de code de programme permettant une mise en oeuvre du procédé selon l'une quelconque des revendications de procédé précédentes lorsqu'il est exécuté sur un dispositif de commande selon l'une quelconque des revendications de dispositif de commande précédentes.

# FIG 1
Stand der Technik

FIG 2

**IN DER BESCHREIBUNG AUFGEFÜHRTE DOKUMENTE**

**In der Beschreibung aufgeführte Patentdokumente**

- EP 2829165 A1
- DE 102015206741 A1
- EP 2829166 B1